# EUROPEAN PATENT SPECIFICATION

(11) **EP 4 703 734 B1**
(45) Date of publication and mention of the grant of the patent: **03.06.2026**
(21) Application number: 24197766.9
(22) Date of filing: 30.08.2024
(51) Int. Cl.: G01R 15/20

(54) **CORELESS CURRENT TRANSDUCER**
KERNLOSER STROMWANDLER
TRANSDUCTEUR DE COURANT SANS NOYAU

(43) Date of publication of application: 04.03.2026
(73) Proprietor: LEM International SA, 1217 Meyrin (CH)
(72) Inventor: BALASSE, Johann, 69420 CONDRIEU (FR); BEJAOUI, Sabri, 38090 VILLEFONTAINE (FR); COUTELLIER, Damien, 01700 MIRIBEL (FR); HARGE, Thomas, 1217 Meyrin (CH); MESSIER, Loïc, 74270 VANZY (FR); ZIGLIOLI, Federico, 1207 Genève (CH)
(74) Representative: reuteler & cie SA

(56) References cited:
- US-A1- 2006 181 264
- US-A1- 2011 006 763
- US-A1- 2013 181 703

## Description

The present invention relates to a coreless current transducer, in particular for measuring high current densities, for instance for electrical vehicle or battery management systems.

Electrical vehicles typically have three phase motors and electrical systems, each phase having a dedicated current transducer that may be positioned in different parts of the electrical system between power supplies, motors, and controllers. Typical electrical parameters in such applications may include currents in a range of 10 to 10k amperes, frequencies from DC to 50kHz, and voltages from 12 volt to 1.2 kvolts.

It is known to provide current transducers comprising a section of primary conductor that is connected (clamped, welded, bolted or soldered) to the phase of the electrical system to be measured, for instance at the output of an inverter or integrated within other electrical systems.

The primary conductor may typically have a substantially rectangular cross section busbar made of copper, aluminum or alloys thereof, around which a ferromagnetic core is mounted having an airgap within which a magnetic field detector is positioned to measure the electrical current flowing in the primary conductor.

It is also known to provide coreless transducers, which have a magnetic field detector positioned in proximity to the primary conductor busbar. The magnetic field sensor may have a pair of magnetic field sensing elements that are separated apart and positioned around a portion of the primary conductor to measure a differential magnetic field, or a magnetic field gradient, that represents the primary current to be measured. The accuracy of the measurement output is however dependent on the precise relative positioning of the magnetic field sensing elements and the primary conductor portion, whereby the positioning is affected by relative displacements caused by mechanical or thermal effects. For instance, the primary conductor will have a different thermal dilatation coefficient than the support on which the magnetic field sensing device is connected. Also, there may be slight manufacturing tolerances in the coupling between the magnetic field sensing device and the primary conductor, or there may be slight displacements in mechanical couplings between the magnetic field sensor and the primary conductor due to vibrations and shocks.

Current transducers with magnetic cores are less sensitive to a relative position between magnetic core and the primary conductor, however such transducers are bulkier and generally more costly than coreless transducers.

Smaller transducers are easier to integrate in the footprints of electronic components, and there is a continuing need to further reduce the size of coreless transducers, since the more compact they are, the easier it is to also reduce the size of the components in which they are integrated. US 2006/181264 A1 discloses a surface-mounted integrated current sensor. Z

In view of the foregoing, it is an object of this invention to provide a coreless current transducer for high current applications that is accurate yet compact and economical to produce.

It is advantageous to provide a coreless current transducer that is robust and reliable in harsh environments subject to mechanical and thermal effects such as found in the automotive applications.

It is advantageous to provide a current transducer that may be easily integrated into electrical systems, in particular of electric vehicles.

Objects of the invention have been achieved by providing a coreless current tranducer according to claim 1.

Dependent claims set out various advantageous features of embodiments of the invention. Disclosed herein is a coreless current transducer comprising :
- a primary conductor having a central section with a substantially rectangular cross-section having a width to height ratio greater than 5, the primary conductor comprising at least one measurement portion,
- a support body comprising an insulating housing having a first side and an opposed second side,
- a magnetic field sensor mounted within the insulating housing, the magnetic field sensor comprising one, or two, or more than two sensing elements, and
- a secondary connection arrangement mounted in the insulating housing for connecting the magnetic field sensor to external power supply and measurement signal processing circuitry, the secondary connection arrangement comprising secondary terminals, each terminal having a chip connection portion electrically connected to the magnetic field sensor and an external connection portion at said second side of the support body for connection to said external power supply and measurement signal processing circuitry.

The support body comprises primary conductor fixing pads positioned on the first side, the primary conductor mounted directly against the first side of the support body and being bonded to the primary conductor fixing pad at the measurement portion by soldering. The bonding may be by welding or by adhesive bonding.

In an embodiment, the insulating housing comprises a polymer overmold, for instance a thermoplastic or thermosetting polymer overmold.

In an embodiment, the primary conductor fixing pads comprises a first stamped and formed leadframe.

In an embodiment, the secondary connection arrangement comprises a second stamped and formed leadframe.

In an embodiment, the primary conductor comprises lateral slots including at least a first lateral slot extending from a first side edge of the primary conductor and a second lateral slot extending from a second side edge of the primary conductor forming the measurement portion of the primary conductor.

In an embodiment, the first and second lateral slots are offset and overlap each other, the measurement portion of the primary conductor being transverse to a general current flow direction of the primary conductor between connection terminals. The primary conductor may be fixed to at least some of the primary conductor fixing pads at outer sides of the first and second lateral slots.

In an embodiment, the primary conductor fixing pads comprise a plurality of rows including a centre row and first and second outer edge rows, each row being formed of a plurality of spaced apart fixing pads.

In an embodiment, the plurality of fixing pads forming said rows extend substantially a whole width between the first and second sides of the primary conductor.

In an embodiment, the sensing elements of the magnetic field sensor are positioned overhead the measurement portion or the lateral slots of the primary conductor.

In an embodiment, the magnetic field sensor comprises at least first and second magnetic field sensing elements, the first magnetic field sensing element being positioned overhead the first lateral slot and the second magnetic field sensing element being positioned overhead the second lateral slot.

In an embodiment, the primary conductor has a U-shape comprising a pair of branches that form a pair of said measurement portions separated by a central slot, the measurement portions joined together at one end by a bridging branch and extending to respective connection terminals at the other end, the magnetic field sensor comprising a pair of sensing elements positioned overhead said pair of measurement portions.

In an embodiment, the magnetic field sensor comprises an integrated circuit chip, having therein Hall effect sensing elements or TMR magnetic field sensing elements.

In an embodiment, the primary conductor extends between connection terminals at opposed ends of the primary conductor, the support body being positioned substantially centrally between the connection terminals.

In an embodiment, the primary conductor extends between connection terminals each connection terminal being configured for a weld, solder, bolt or mechanical clamping connection in series to a conductor carrying the current to be measured.

In an embodiment, the secondary connection arrangement comprises contact pins upstanding from the second side of the support body or by contact pads at the second side of the support body.

Also disclosed herein is a multiphase current transducer arrangement comprising a plurality of current transducers according to any of the preceding embodiments.

In an embodiment, the multiphase current transducer is a three-phase current transducer arrangement, including a housing securing three said current transducers and a support body connected to the secondary connection arrangement of the three current transducers.

Further advantageous features of the invention will be apparent from the following detailed description of embodiments of the invention and the accompanying illustrations.

### Brief description of the figures

Figure 1a is a perspective view of a current transducer according to an embodiment of the invention;
Figure 1b is an exploded perspective view from a bottom side of embodiment of figure 1a;
Figure 1c is an exploded perspective view of a portion of a current transducer module of embodiment of figure 1a;
Figure 1d is a cross-sectional view of the embodiment of figure 1a;
Figure 2 is a perspective view of a current transducer according to another embodiment of this invention;
Figure 3 is a cross-sectional view similar to figure 1d of yet another embodiment of the invention;
Figure 4a is a perspective view of a multiphase current transducer arrangement with current transducers according an embodiment of the invention;
Figure 4b is a view of the multiphase current transducer arrangement of figure 4a with a housing and circuit board removed;
Figure 4c is view similar to figure 4b of a variant;
Figure 5a is a schematic perspective view of a current transducer module of a current transducer according to an embodiment of the invention;
Figure 5b is a view of the current transducer module of figure 5a showing in dotted outline the position of the primary conductor and of magnetic sensing elements, according to an embodiment of the invention;
Figure 6a is a schematic perspective view of a variant of the current transducer module of figure 5a according to an embodiment of the invention;
Figure 6b is a view of the current transducer module of figure 6a showing in dotted outline the position of the primary conductor and of magnetic sensing elements, according to an embodiment of the invention;
Figure 7a is a perspective view of a primary conductor of a current transducer according to another embodiment of the invention;
Figure 7b is a view of a current transducer module for fixing on the primary conductor of figure 7a, according to an embodiment of the invention;
Figure 8a is a perspective view of a primary conductor of a current transducer according to another embodiment of the invention;
Figure 8b is a view of a current transducer module for fixing on the primary conductor of figure 8a, according to an embodiment of the invention;
Figures 9a to 9h are schematic plan views of the layout of primary conductor, magnetic field sensor and primary conductor transducer module fixing pads of current transducers according to different embodiments of the invention.

Referring to the figures, a current transducer 1 according to embodiments of the invention comprises a primary conductor 3 and a current transducer module 2 configured for mounting on the primary conductor, the current transducer module 2 comprising a support body 4, and a magnetic field sensor 5 integrated within the support body 4.

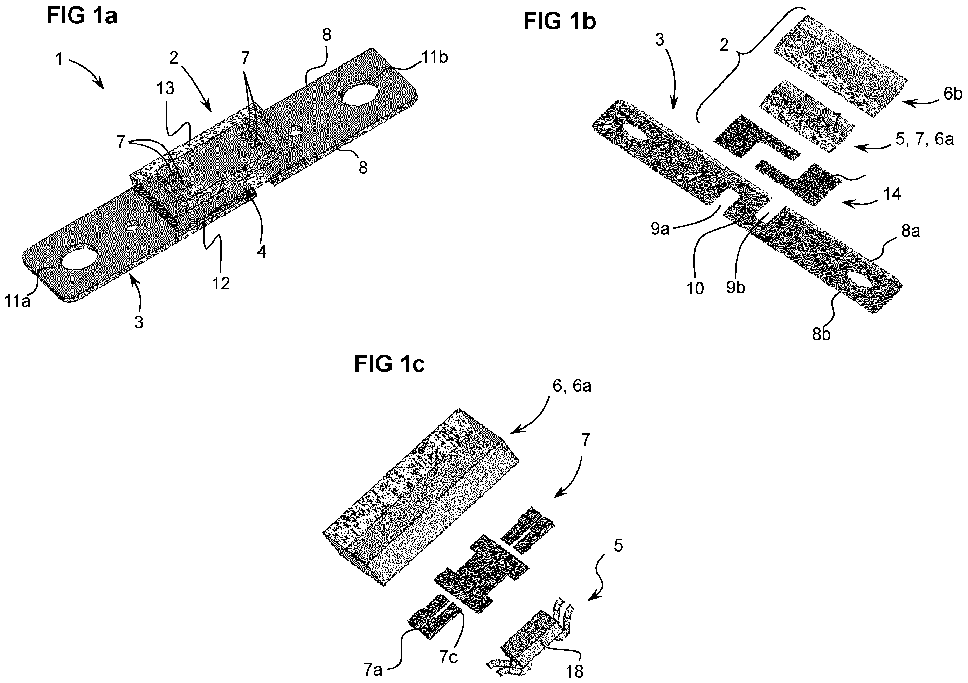

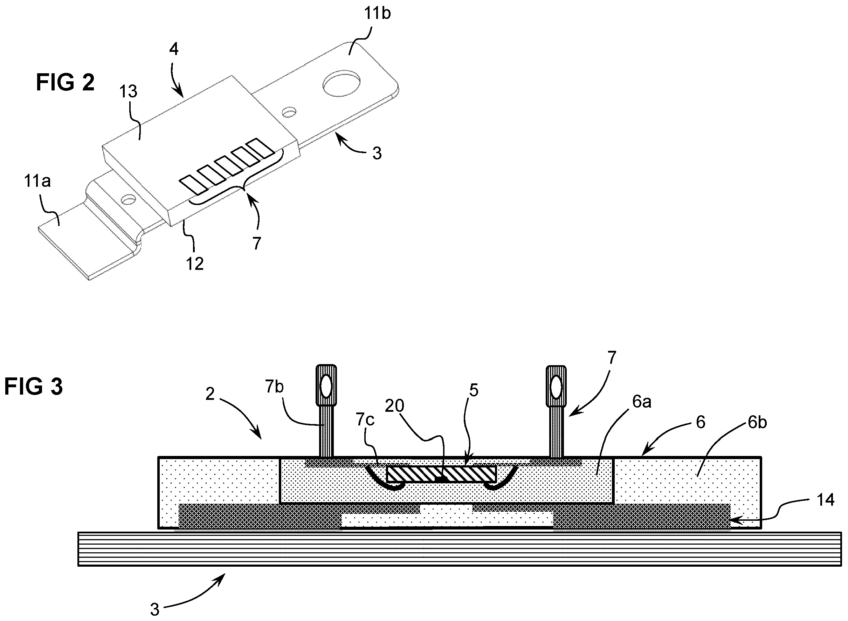

The primary conductor 3 is in the form of what is commonly known as a busbar that has a generally rectangular cross section with a width to height ratio that is typically greater than 5 and having a generally planar central section extending between connection terminals 11a, 11b at ends of the busbar. The connection terminals may have various shapes and dimensions that are adapted for connection to complimentary terminals of a conductor carrying the current to be measured. The connection terminals may comprise a hole for a bolt, or a bent foot for a solder or weld connection, or various other forms *per se* known for mechanical, weld, or solder connections. The connection terminals at opposed ends of the primary conductor 3 may also be different, for instance as illustrated in the example embodiment of figure 2, or may be the same, for instance as illustrated in the example embodiment of figure 1a. For instance, one end of the transducer may be clamped, welded or bolted to an output of an inverter, and the other end to a cable or other form of conductor connected to an electrical component supplied with power from the inverter. The current transducers are thus connected in line with the conductor carrying the current to be measured.

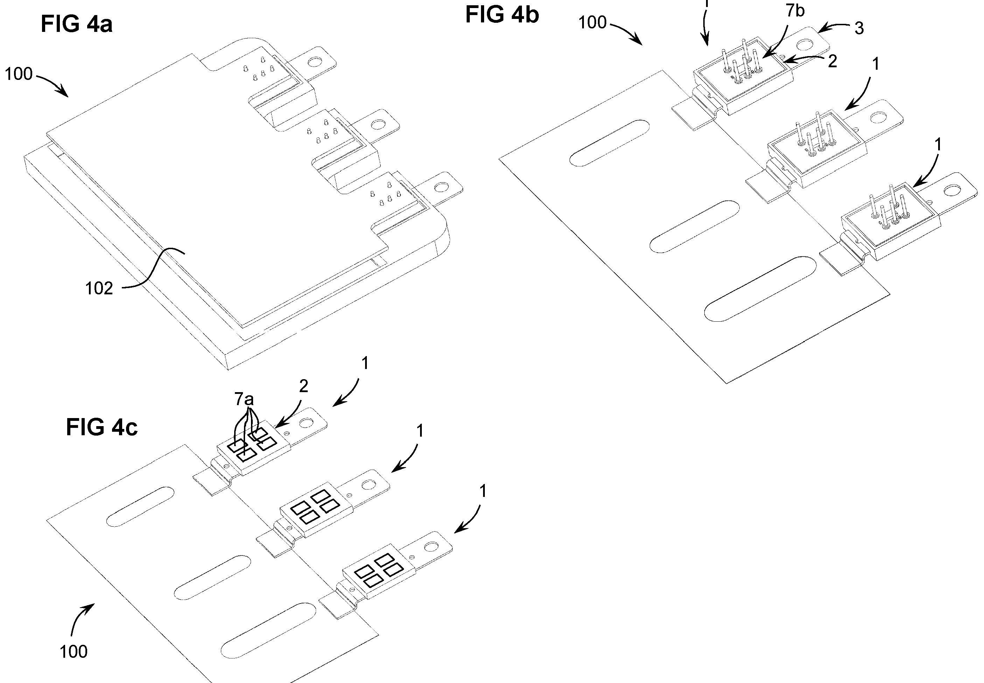

The current transducer 1 may be part of a multiphase current transducer arrangement 100 as illustrated in figures 4a to 4c, for instance a three-phase arrangement. Each electrical phase may comprise its own current transducer. Typical maximum currents that flow through the transducer in applications such as in electrical vehicles may be in a range of 100 to 1500 amperes. In such applications, the cross-sectional area of the primary conductor busbar, which is often made of copper or aluminum alloy, will be typically in a range of 10 to 70 mm².

The primary conductor 3 has substantially parallel side edges 8 that define the width of the busbar.

In some embodiments (see figures 1b, 5b, 6b, 9a, 9b) the primary conductor 3 comprises at least two lateral slots 9a, 9b, a first lateral slot 9a extending from one of the side edges 8a and a second lateral slot 9b extending from the opposed second side edge 8b such that a reduced cross-section measurement portion 10 is formed. Preferably, the second lateral slot 9b is spaced apart from the first lateral slot in the general direction of current flow between connection terminals 11a, 11b, such that the current flowing through the primary conductor from one connection terminal 11a to the other connection terminal 11b goes through a meandering path. The lateral slots overlap each other such that a transversely oriented measurement portion 10 is formed between the pair of lateral slots 9a, 9b. In this advantageous embodiment, the primary current flowing through the measurement portion 10 has a transverse flow direction to the general direction of current flow between the connection terminals 11a, 11b.

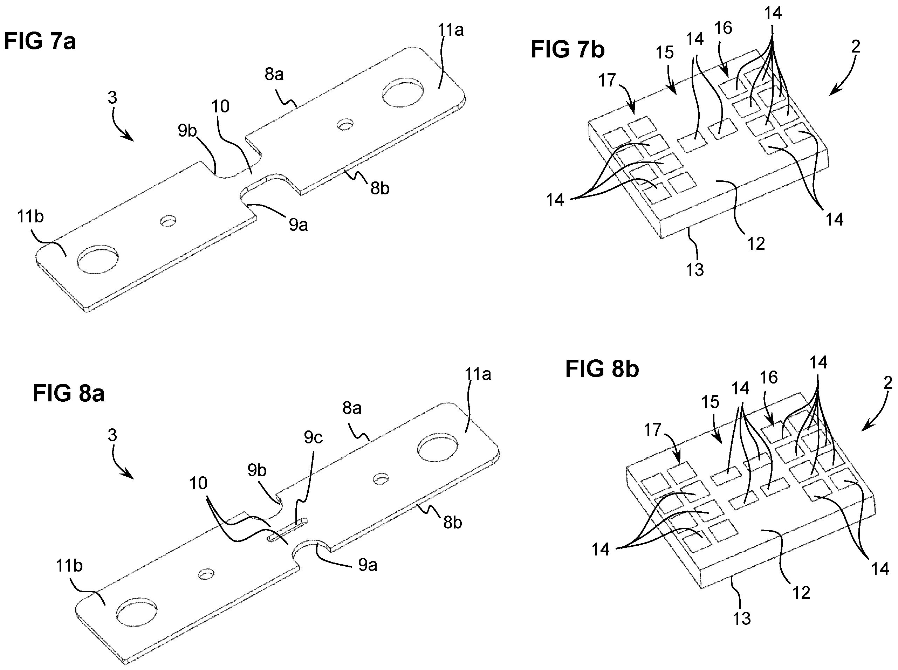

In variants, it is possible to have other shapes of measurement portions that concentrate the current to be measured, that are not based on a transverse current flow direction as illustrated in figures 7a and 8a and figures 9c to 9d. For instance indents 9a, 9b that are not offset but aligned and simply create a narrow section of the primary conductor measurement portion 10 may also be provided. Also, a centre slot 9c may be provided as illustrated in figure 8a.

The smaller section measurement portion 10 has a higher current density than the adjoining sections of the primary conductor, to increase the magnetic field intensity in the proximity of the centre measurement section, as *per se* known in coreless current transducers.

The magnetic field sensor 5 comprises one or more magnetic field sensing elements 20 that are positioned overhead the lateral slots 9 and/or measurement portion 10.

If there is a single sensing element on the magnetic field sensor, it is preferably positioned overhead the measurement portion 10. If the magnetic field sensor comprises two or at least two sensing elements 20, they may be positioned over edges of the measurement portion 10. In the illustrated embodiments of figures 1b, 5b, 6b, 9a, 9b with a transversely oriented measurement portion, at least one of the two sensing elements 20 may be positioned overhead the first lateral slot 9a and a second of the least two sensing elements may be positioned overhead the second lateral slot 9b.

The sensing element(s) 20 may be configured to measure a magnetic field that is orthogonal to the surface of the support body 4 within which the magnetic field sensor is mounted, for instance Hall effect sensors measuring a current flowing through the measurement portion 10. In a variant, the sensing elements may comprise tunnel magnetoresistance (TMR) sensors that measure an in-plane magnetic field gradient, representative of the current flowing through the measurement portion 10 of the primary conductor 3.

The support body 4 comprises a first side 12 corresponding to a primary conductor mounting side, and a second opposed side 13 corresponding to a secondary conductor connection side.

The magnetic field sensor 5 is mounted adjacent the second side 13 and may in particular comprise an integrated circuit chip 18 that includes the one or more sensing elements 20 as *per se* well known in the art, the integrated circuit chip 18 being connected to a secondary conductor arrangement adjacent the second side of the support body, for instance by wire bonding, as *per se* well known in the art.

The transducer includes a secondary connection arrangement 7 for transmission of power and measurement signals between the magnetic field sensor 5 and an external system. The secondary connection arrangement 7 comprises a plurality of secondary terminals, each terminal comprising a chip connection portion 7c embedded in the insulating housing 6, and an external connection portion 7a, 7b accessible from outside the insulating housing for connection to the external system.

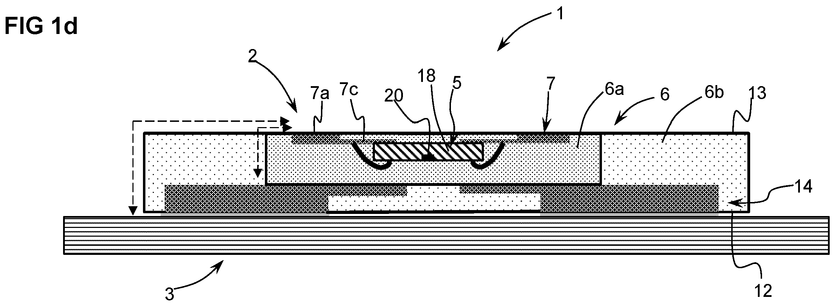

The external connection portion may comprise a pin contact 7b such as illustrated in the embodiments of figures 2 and 4b, or may comprise a contact pad 7a such as illustrated in the embodiments of figures 1a, 1d, and 4c, or may comprise other *per se* known connection elements (not shown). The pin contacts 7b or other *per se* known connection elements may be welded or soldered to the contact pads, or may be integrally formed with the chip connection portion 7c.

In an embodiment, the secondary connection arrangement 7 may advantageously be stamped and formed from a leadframe. The magnetic field sensor 5 may be connected to the chip connection portions 7c of the secondary terminals by wire bonding or by solder beads in a flip-chip connection, both wire bonding and flip-chip connections being *per se* well known. The difference between flip chip and wire bonding will be the position of the sensing elements relative to the lead frame 7. The magnetic field sensor 5 connected to the secondary connection arrangement 7 may then be overmolded by the insulating housing 6, leaving the external connection portions 7a, 7b exposed for connection to the external system. It may be noted that the conductor materials of the leadframe and wirebonding may be copper, aliuminium or other *per se* known leadframe and wirebonding materials, whereby the interconnection between the chip connection portion and wirebonds should have compatible metallurgy.

The insulating housing may comprise a first overmold 6a, in which the magnetic field sensor 5 and secondary connection arrangement 7 are embedded, and a second overmold 6b that encapsulates at least partially the first overmold 6a and primary conductor fixing pads 14 described in more detail below.

According to an aspect of the invention, on the first side 12 of the support body 4, primary conductor fixing pads 14 mounted in the insulating housing 6 are provided for direct solder attachment of the primary conductor 3 against the second side 13 of the support body 4 at least in the vicinity of the measurement portion 10.

In an embodiment, the primary conductor fixing pads 14 may advantageously be stamped and formed from a leadframe and overmolded by the insulating housing 6.

In some embodiments, the primary conductor fixing pads 14 are preferably arranged such that there is at least one or more centre pads 15 that attaches to the measurement portion 10 of the primary conductor.

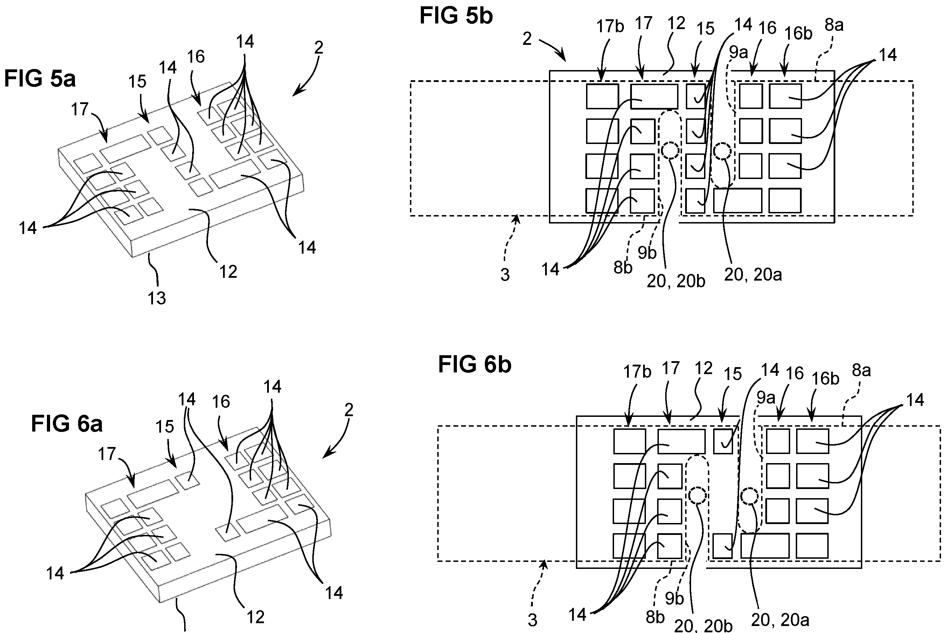

In the illustrated embodiment of figures 5a to 6b and 9a and 9b with lateral offset slots forming the transversely oriented measurement portion 10, there are provided at least first and second outer edge rows 16, 17 of fixing pads that attach to the primary conductor adjacent outer edges of the first lateral slot 9a and second lateral slot 9b respectively. The primary conductor 3 is thus securely attached to the support body along edges of each lateral slot, whereby there may be additional rows 16b, 17b adjacent the outer edge rows 16, 17 for a more secure attachment of the primary conductor to the support body as illustrated in figures 5a to 6b. The primary conductor fixing pads 14 may be arranged in rows that extend across from one side edge 8a of the primary conductor to the other side edge 8b.

In the other embodiments as illustrated in figures 7a to 8b, there may also be provided at least first and second outer edge rows 16, 17 of fixing pads that attach to the primary conductor adjacent ends of the measurement portion 10.

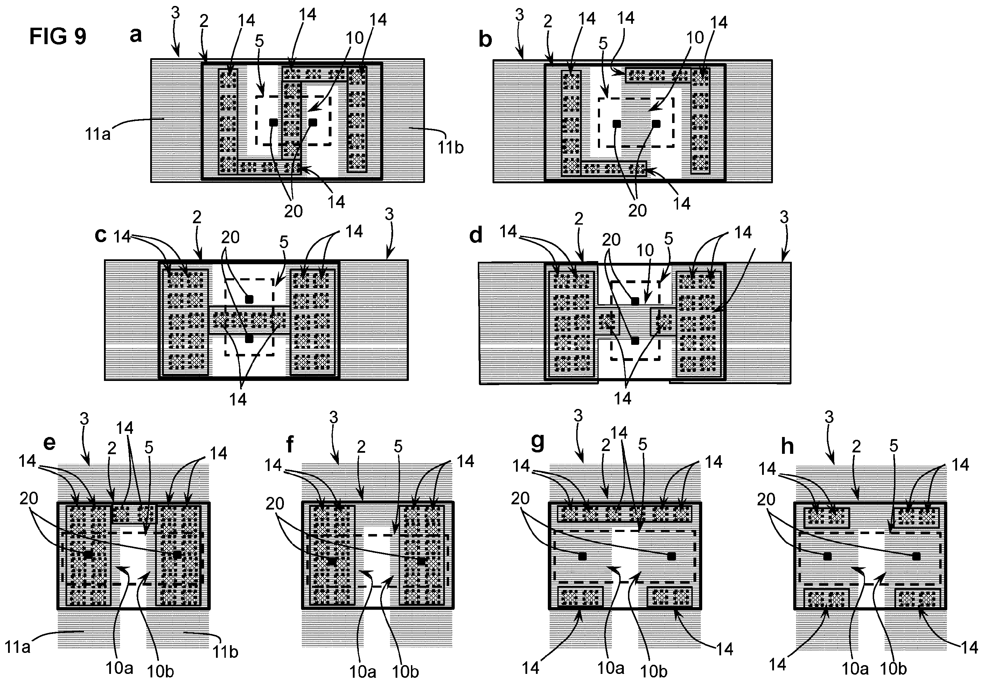

In figures 9e to 9h, embodiments with a U-shaped primary conductor 3 are illustrated. The U-shaped primary conductor comprises branches that form measurement portions 10a, 10b separated by a central slot 9, the measurement portions joined together at one end by a bridging branch 10c and extending to respective connection terminals 11a, 11b at the other end. The magnetic field sensor 5 comprises a pair of sensing elements 20 positioned overhead respective branch measurement portions 10a, 10b of the U-shape primary conductor. The pair of sensor elements may for instance be configured to measure an in-plane magnetic field gradient, such primary conductor and sensor element dispositions and functioning being *per se* known.

The primary conductor fixing pads 14 of the current transducer module are advantageously provided in at least first and second outer edge rows 16, 17 of fixing pads that attach to the primary conductor over the measurement portions 10a, 10b adjacent outer edges of the central slot 9. The primary conductor 3 is thus securely attached to the support body along the measurement portions 10a, 10b for accurate placement of the primary conductor relative to the sensing elements 20 and secure attachment of the primary conductor to the support body. In certain variants, as illustrated in figure 9e and 9g, one or more fixing pads may also be positioned over the bridging branch of the U-shape primary conductor.

The fixing pads serve to fix the primary conductor securely to the support body in a direct solder attachment for instance via a solder reflow connection, that is well known in electronic connection technology, or by welding, for instance spot welding the primary conductor to the corresponding fixing pads. In addition to the solder or weld connection, adhesive bonding material may be provided between the support body and the primary conductor.

The fixing pads 14 are preferably configured as individual pads that are spaced apart from each other such that the primary conductor is fixed to the support body in a plurality of discrete positions. This allows solder to flow more evenly for an accurate control of the spacing between the primary conductor and the first side 12 of the support body, in particular to have a minimal spacing therebetween.

The direct solder attachment of the measurement portion(s) 10, 10a, 10b of the primary conductor, as well as the direct solder attachment of the primary conductor on outer edges of the slots 9, 9a, 9b very securely and rigidly fixes and adjusts the position of the measurement portion(s) 10, 10a, 10b with respect to the position of the magnetic field sensor 5 and the associated sensing elements 20 adjacent the second side of the support body.

Contrary to conventional devices, the localized attachment of the measurement portion in a solder connection ensures a very accurate dimensional positioning of the measurement portion relative to the magnetic field sensor, which is not affected by thermal dilatation of the components, nor by mechanical stresses. Moreover the positioning of the secondary conductor external connection portions 7a, 7b and primary conductor 3 on opposite sides 12, 13 of the support body allows to benefit from the surface area of the insulating material of the support body housing 6 to easily provide a large electrical creepage distance.

In a preferred embodiment, soldering the primary conductor to fix the measurement portion(s) accurately with respect to the magnetic field sensor can be performed with *per se* conventional solder reflow techniques.

The insulating housing 6 of the support body may be made of *per se* known insulating materials, for instance including thermosetting or thermoplastic polymers, which have a lower thermal expansion coefficient than metals such as copper or aluminum used for the primary conductor.

In the illustrated embodiments, the rigid attachment of the primary conductor along the edges of the slot(s) 9, 9a, 9b further assists the very accurate positioning of the sensing elements 20 with respect to the primary conductor with a low variability over a large temperature range. Also, mechanical stresses and vibration do not shift the position of the sensing elements 20 with respect to the primary conductor measurement portion(s) 10, 10a, 10b and slot(s) 9, 9a, 9b. Moreover, the direct attachment of the primary conductor via the fixing pads 14 on the surface of the support body first side 12 ensures that the primary conductor is as close as possible to the magnetic field sensor elements 20 on the IC chip 18 positioned adjacent the second side 13 of the support body. Advantageously, the arrangement of the fixing pads and the lead frame forming the fixing pads, and their direct soldering on the primary conductor, further contribute to the mechanical robustness of the transducer.

An additional advantage of the described arrangement is that the support body housing insulating material, and the central position of the magnetic field sensor 5 therein acts to provide a large electrical creepage distance *Lc*1, *Lc2* between the secondary connection arrangement 7 and the primary conductor 3. The primary conductor 3 is spaced from the magnetic field sensor 5 on the other side of the support body by a large creepage distance that is defined by the central position of the magnetic field sensor 5 in the support body to the edges of the support body, whereby the support body may be dimensioned in width and length to adjust the creepage distance.

The current transducer 1 may be interconnected to external electronics for power supply and measurement signal processing by way of a circuit board 102 connected to the secondary connection arrangement 7 of the current transducer 1, whereby a plurality of current transducers may be connected to a single circuit board 102 for instance as illustrated in the multiphase current transducer arrangement 100 of figure 5a. The circuit board 102 of the multiphase current transducer arrangement 100 illustrated in figure 5a may comprise further electronic components of an external system for instance of a multiphase current inverter. The current transducer connection terminals that are outside of the multiphase current transducer arrangement 100 may be for plugging, clamping or bolt connection to conductor cables or other conductor systems supplied with the phase currents.

### List of references

Multiphase current transducer arrangement 100
Circuit board 102
Current transducer 1
   **Primary conductor 3**
      *Straight Busbar*
         Side edges 8
         Lateral slots 9a, 9b
            First lateral slot 9a
            Second lateral slot 9b
         Centre slot 9c
         Measurement portion 10
         Connection terminals 11a, 11b
      *U-Shaped busbar*
         U-shaped centre slot 9
         First measurement portion 10a
         Second measurement portion 10b
         Bridging branch 10c
         Connection terminals 11a, 11b
   **Current transducer module 2**
      **Support body 4**
         **Insulating housing 6**
            Polymer overmold 6a, 6b
            First overmold 6a
            Second overmold 6b
         First side (primary conductor mounting side) 12
         Second side (magnetic field sensor mounting side) 13
         **Primary conductor fixing pads 14**
            Measurement portion pads 15
            First and second side pads 16, 17
      **Magnetic field sensor 5**
         IC chip 18
            Sensing elements 20
         Wire bond connections
      **Secondary connection arrangement 7**
         Terminal
         Chip connection portion 7c
         External connection portion 7a, 7b
            Pin contact 7b
            Contact pad 7a

## Claims

1. A coreless current transducer (1) comprising :
- a primary conductor (3) having a central section with a substantially rectangular cross-section having a width to height ratio greater than 5, the primary conductor (3) comprising at least one measurement portion (10),
- a support body (4) comprising an insulating housing (6) having a first side (12) and an opposed second side (13),
- a magnetic field sensor (5) mounted within the insulating housing, the magnetic field sensor (5) comprising one, or two, or more than two sensing elements (20), and
- a secondary connection arrangement (7) mounted in the insulating housing for connecting the magnetic field sensor (5) to external power supply and measurement signal processing circuitry, the secondary connection arrangement comprising secondary terminals, each secondary terminal having a chip connection portion (7c) electrically connected to the magnetic field sensor, **characterised in that** the secondary connection arrangement (7) comprises an external connection portion (7a, 7b) at said second side (13) of the support body (4) for connection to said external power supply and measurement signal processing circuitry, wherein the support body (4) comprises primary conductor fixing pads (14) positioned on the first side (12), the primary conductor (3) mounted directly against the first side (12) of the support body (4) and being soldered to the primary conductor fixing pads (14) at or bounding the at least one measurement portion (10).

2. The coreless current transducer according to claim 1 wherein the insulating housing (6) comprises a polymer overmold, for instance a thermoplastic or thermosetting polymer overmold.

3. The coreless current transducer according to any preceding claim wherein the primary conductor fixing pads (14) comprise a first stamped and formed leadframe.

4. The coreless current transducer according to any preceding claim wherein the secondary connection arrangement (7) comprises a second stamped and formed leadframe.

5. The coreless current transducer according to any preceding claim wherein the primary conductor (3) comprises lateral slots (9a, 9b) including at least a first lateral slot (9a) extending from a first side edge (8a) of the primary conductor and a second lateral slot (9b) extending from a second side edge (8b) of the primary conductor, the measurement portion formed between said lateral slots.

6. The coreless current transducer according to the preceding claim wherein the first and second lateral slots are offset and overlap each other, the measurement portion (10) of the primary conductor being transverse to a general current flow direction of the primary conductor between connection terminals (11a, 11b), wherein the primary conductor is fixed to at least some of the primary conductor fixing pads (14) at outer sides of the first and second lateral slots.

7. The coreless current transducer according to any of the two directly preceding claims wherein the primary conductor fixing pads comprise a plurality of rows including a centre row (15) and first and second outer edge rows (16), each row being formed of a plurality of spaced apart fixing pads.

8. The coreless current transducer according to the preceding claim wherein the plurality of fixing pads forming said rows extend substantially a whole width between the first and second sides (8) of the primary conductor.

9. The coreless current transducer according to any preceding claim 5-8 wherein the sensing elements (20) of the magnetic field sensor are positioned overhead the measurement portion (10) or the lateral slots (9) of the primary conductor.

10. The coreless current transducer according to any preceding claim 5-9 wherein the magnetic field sensor comprises at least first and second magnetic field sensing elements (20), the first magnetic field sensing element being positioned overhead the first lateral slot (9a) and the second magnetic field sensing element being positioned overhead the second lateral slot (9b).

11. The coreless current transducer according to any preceding claim 1-4 wherein the primary conductor has a U-shape comprising a pair of branches that form a pair of said measurement portions (10a, 10b) separated by a central slot (9), the measurement portions joined together at one end by a bridging branch (10c) and extending to respective connection terminals (11a, 11b) at the other end, the magnetic field sensor (5) comprising a pair of sensing elements (20) positioned overhead said pair of measurement portions.

12. The coreless current transducer according to any preceding claim wherein the magnetic field sensor (5) comprises an integrated circuit chip (18), having therein Hall effect sensing elements or TMR magnetic field sensing elements.

13. The coreless current transducer according to any preceding claim wherein the primary conductor (3) extends between connection terminals (11a, 11b) each connection terminal being configured for a weld, solder, bolt or mechanical clamping connection in series to a conductor carrying the current to be measured.

14. The coreless current transducer according to any preceding claim wherein the secondary connection arrangement (7) comprising contact pins (7b) upstanding from the second side (13) of the support body (4) or by contact pads (7a) at the second side (13) of the support body.

15. A multiphase current transducer arrangement (100) comprising a plurality of coreless current transducers (1) according to any of the preceding claims.

## Patentansprüche

1. Kernloser Stromwandler (1), der Folgendes umfasst:
- einen primären Leiter (3), der einen zentralen Bereich mit einem im Wesentlichen rechteckigen Querschnitt mit einem Breite-zu-Höhe-Verhältnis von großer als 5 aufweist, wobei der primäre Leiter (3) mindestens einen Messabschnitt (10) umfasst,
- einen Stützkörper (4), der ein Isoliergehäuse (6) mit einer ersten Seite (12) und einer gegenüberliegenden zweiten Seite (13) aufweist,
- einen Magnetfeldsensor (5), der im Isoliergehäuse montiert ist, wobei der Magnetfeldsensor (5) ein oder zwei oder mehr als zwei Erfassungselemente (20) umfasst, und
- eine sekundäre Verbindungsanordnung (7), die im Isoliergehäuse montiert ist, zum Verbinden des Magnetfeldsensors (5) mit einer äußeren Stromversorgung und einer Messsignalverarbeitungsschaltung, wobei die sekundäre Verbindungsanordnung sekundäre Anschlüsse umfasst, wobei jeder sekundäre Anschluss einen Chipverbindungsabschnitt (7c) aufweist, der elektrisch mit dem Magnetfeldsensor verbunden ist, **dadurch gekennzeichnet, dass** die sekundäre Verbindungsanordnung (7) einen äußeren Verbindungsabschnitt (7a, 7b) auf der zweiten Seite (13) des Stützkörpers (4) zur Verbindung mit der äußeren Stromversorgung und der Messsignalverarbeitungsschaltung umfasst, wobei der Stützkörper (4) primäre Leiterfixierauflagen (14) umfasst, die auf der ersten Seite (12) positioniert sind, wobei der primäre Leiter (3) direkt an der ersten Seite (12) des Stützkörpers montiert und an die primären Leiterfixierauflagen (14) an dem mindestens einen Messabschnitt (10) oder an diesen angrenzend angelötet ist.

2. Kernloser Stromwandler nach Anspruch 1, wobei das Isoliergehäuse (6) eine Polymerüberspritzung umfasst, beispielsweise eine Thermoplast- oder eine Duroplastpolymerüberspritzung.

3. Kernloser Stromwandler nach einem der vorhergehenden Ansprüche, wobei die primären Leiterfixierauflagen (14) einen ersten gestanzten und geformten Leiterrahmen umfassen.

4. Kernloser Stromwandler nach einem der vorhergehenden Ansprüche, wobei die sekundäre Verbindungsanordnung (7) einen zweiten gestanzten und geformten Leiterrahmen umfasst.

5. Kernloser Stromwandler nach einem der vorhergehenden Ansprüche, wobei der primäre Leiter (3) seitliche Schlitze (9a, 9b) umfasst, die mindestens einen ersten seitlichen Schlitz (9a), der sich von einer ersten Seitenkante (8a) des primären Leiters erstreckt, und einen zweiten seitlichen Schlitz (9b), der sich von einer zweiten Seitenkante (8b) des primären Leiters erstreckt, beinhalten, wobei der Messabschnitt zwischen den seitlichen Schlitzen geformt ist.

6. Kernloser Stromwandler nach dem vorhergehenden Anspruch, wobei die ersten und die zweiten seitlichen Schlitze versetzt sind und einander überlappen, wobei der Messabschnitt (10) des primären Leiters quer zu einer allgemeinen Stromflussrichtung des primären Leiters zwischen den Verbindungsanschlüssen (11a, 11b) verläuft, wobei der primäre Leiter an Außenseiten der ersten und der zweiten seitlichen Schlitze an mindestens einigen der primären Leiterfixierauflagen (14) fixiert ist.

7. Kernloser Stromwandler nach einem der zwei direkt vorhergehenden Ansprüche, wobei die primären Leiterfixierauflagen eine Vielzahl von Reihen umfassen, die eine zentrale Reihe (15) und erste und zweite Außenkantenreihen (16) umfassen, wobei jede Reihe aus einer Vielzahl von beabstandeten Fixierauflagen gebildet ist.

8. Kernloser Stromwandler nach dem vorhergehenden Anspruch, wobei die Vielzahl von Fixierauflagen, die die Reihen formen, sich um im Wesentlichen eine Gesamtbreite zwischen der ersten und der zweiten Seite (8) des primären Leiters erstrecken.

9. Kernloser Stromwandler nach einem der vorhergehenden Ansprüche 5 bis 8, wobei die Erfassungselemente (20) des Magnetfeldsensors über dem Messabschnitt (10) oder den seitlichen Schlitzen (9) des primären Leiters positioniert sind.

10. Kernloser Stromwandler nach einem der vorhergehenden Ansprüche 5 bis 9, wobei der Magnetfeldsensor mindestens ein erstes und ein zweites Magnetfelderfassungselement (20) umfasst, wobei das erste Magnetfelderfassungselement über dem ersten seitlichen Schlitz (9a) positioniert ist und wobei das zweite Magnetfelderfassungselement über dem zweiten seitlichen Schlitz (9b) positioniert ist.

11. Kernloser Stromwandler nach einem der vorhergehenden Ansprüche 1 bis 4, wobei der primäre Leiter eine U-Form aufweist, die ein Paar von Abzweigen umfasst, die ein Paar der Messabschnitte (10a, 10b) formen, die durch einen zentralen Schlitz (9) getrennt sind, wobei die Messabschnitte an einem Ende durch einen Überbrückungsabzweig (10c) verbunden sind und sich zu jeweiligen Verbindungsanschlüssen (11a, 11b) am anderen Ende erstrecken, wobei der Magnetfeldsensor (5) ein Paar von Erfassungselementen (20) umfasst, die über dem Paar von Messabschnitten positioniert sind.

12. Kernloser Stromwandler nach einem der vorhergehenden Ansprüche, wobei der Magnetfeldsensor (5) einen integrierten Schaltungschip (18) umfasst, in dem sich Halleffekterfassungselemente oder TMR-Magnetfelderfassungselemente befinden.

13. Kernloser Stromwandler nach einem der vorhergehenden Ansprüche, wobei sich der primäre Leiter (3) zwischen Verbindungsanschlüssen (11a, 11b) erstreckt, wobei jeder Verbindungsanschluss für eine Schweiß-, Löt-, Schraub- oder mechanische Klemmverbindung in Reihe zur einem Leiter ausgelegt ist, in dem der zu messende Strom fließt.

14. Kernloser Stromwandler nach einem der vorhergehenden Ansprüche, wobei die sekundäre Verbindungsanordnung (7) Kontaktstifte (7b), die von der zweiten Seite (13) des Stützkörpers (4) hochstehen, oder Kontaktauflagen (7a) auf der zweiten Seite (13) des Stützkörpers umfasst.

15. Mehrphasenstromwandleranordnung (100), die eine Vielzahl von kernlosen Stromwandlern (1) nach einem der vorhergehenden Ansprüche umfasst.

## Revendications

1. Transducteur de courant sans noyau (1) comprenant :
- un conducteur primaire (3) ayant une section centrale de section transversale sensiblement rectangulaire dont un rapport largeur-sur-hauteur est supérieur à 5, le conducteur primaire (3) comprenant au moins une partie de mesure (10),
- un corps de support (4) comprenant un boîtier isolant (6) ayant un premier côté (12) et un deuxième côté (13) opposé,
- un capteur de champ magnétique (5) monté à l'intérieur du boîtier isolant, le capteur de champ magnétique (5) comprenant un, deux ou plus de deux éléments de détection (20), et
- un agencement de connexion secondaire (7) monté dans le boîtier isolant pour connecter le capteur de champ magnétique (5) à une alimentation de puissance externe et à un ensemble de circuits de traitement de signaux de mesure, l'agencement de connexion secondaire comprenant des bornes secondaires, chaque borne secondaire ayant une partie de connexion de puce (7c) connectée électriquement au capteur de champ magnétique, **caractérisé en ce que** l'agencement de connexion secondaire (7) comprend une partie de connexion externe (7a, 7b) sur ledit deuxième côté (13) du corps de support (4) pour la connexion à ladite alimentation de puissance externe et audit ensemble de circuits de traitement de signaux de mesure, dans lequel le corps de support (4) comprend des plots de fixation de conducteur primaire (14) positionnés sur le premier côté (12), le conducteur primaire (3) étant monté directement contre le premier côté (12) du corps de support (4) et étant brasé sur les plots de fixation de conducteur primaire (14) au niveau de l'au moins une partie de mesure (10) ou la délimitant.

2. Transducteur de courant sans noyau selon la revendication 1, dans lequel le boîtier isolant (6) comprend un surmoulage en polymère, par exemple un surmoulage en polymère thermoplastique ou thermodurcissable.

3. Transducteur de courant sans noyau selon l'une des revendications précédentes, dans lequel les plots de fixation de conducteur primaire (14) comprennent une première grille de connexion estampée et formée.

4. Transducteur de courant sans noyau selon l'une des revendications précédentes, dans lequel l'agencement de connexion secondaire (7) comprennent une deuxième grille de connexion estampée et formée.

5. Transducteur de courant sans noyau selon l'une des revendications précédentes, dans lequel le conducteur primaire (3) comprend des fentes latérales (9a, 9b) comportant au moins une première fente latérale (9a) s'étendant depuis un premier bord sur le côté (8a) du conducteur primaire et une deuxième fente latérale (9b) s'étendant depuis un deuxième bord sur le côté (8b) du conducteur primaire, la partie de mesure étant formée entre lesdites fentes latérales.

6. Transducteur de courant sans noyau selon la revendication précédente, dans lequel les première et deuxième fentes latérales sont décalées et se chevauchent, la partie de mesure (10) du conducteur primaire étant transversale à une direction globale de circulation de courant du conducteur primaire entre des bornes de connexion (11a, 11b), dans lequel le conducteur primaire est fixé à au moins certains des plots de fixation de conducteur primaire (14) sur des côtés extérieurs des première et deuxième fentes latérales.

7. Transducteur de courant sans noyau selon l'une des deux revendications directement précédentes, dans lequel les plots de fixation de conducteur primaire comprennent une pluralité de rangées comportant une rangée centrale (15) et des première et deuxième rangées de bord extérieures (16), chaque rangée étant formée d'une pluralité de plots de fixation espacés les uns des autres.

8. Transducteur de courant sans noyau selon la revendication précédente, dans lequel la pluralité de plots de fixation formant lesdites rangées s'étendent sensiblement sur toute la largeur ente les premier et deuxième côtés (8) du conducteur primaire.

9. Transducteur de courant sans noyau selon l'une des revendications précédentes 5 à 8, dans lequel les éléments de détection (20) du capteur de champ magnétique sont positionnés au-dessus de la partie de mesure (10) ou des fentes latérales (9) du conducteur primaire.

10. Transducteur de courant sans noyau selon l'une des revendications précédentes 5 à 9, dans lequel le capteur de champ magnétique comprend au moins des premier et deuxième éléments de détection de champ magnétique (20), le premier élément de détection de champ magnétique étant positionné au-dessus de la première fente latérale (9a), et le deuxième élément de détection de champ magnétique étant positionné au-dessus de la deuxième fente latérale (9b).

11. Transducteur de courant sans noyau selon l'une des revendications précédentes 1 à 4, dans lequel le conducteur primaire est en forme de U et comprend une paire de branches qui forment une paire desdites parties de mesure (10a, 10b) séparées par une fente centrale (9), les parties de mesure étant reliées les unes aux autres sur une extrémité par une branche de pontage (10c) et s'étendant vers des bornes de connexion (11a, 11b) respectives sur l'autre extrémité, le capteur de champ magnétique (5) comprenant une paire d'éléments de détection (20) positionné au-dessus de ladite paire de parties de mesure.

12. Transducteur de courant sans noyau selon l'une des revendications précédentes, dans lequel le capteur de champ magnétique (5) comprend une puce de circuit intégré (18) dans laquelle se trouvent des éléments de détection à effet Hall ou des éléments de détection de champ magnétique TMR.

13. Transducteur de courant sans noyau selon l'une des revendications précédentes, dans lequel le conducteur primaire (3) s'étend entre des bornes de connexion (11a, 11b), chaque borne de connexion étant configurée pour une connexion par soudage, brasage, boulonnage ou serrage mécanique en série à un conducteur transportant le courant à mesurer.

14. Transducteur de courant sans noyau selon l'une des revendications précédentes, dans lequel l'agencement de connexion secondaire (7) comprend des broches de contact (7b) se dressant depuis le deuxième côté (13) du corps de support (4) ou des plots de contact (7a) sur le deuxième côté (13) du corps de support.

15. Agencement de transducteurs de courant multiphasé (100) comprenant une pluralité de transducteurs de courant sans noyau (1) selon l'une des revendications précédentes.
